# EUROPEAN PATENT SPECIFICATION

(11) **EP 4 602 380 B1**
(45) Date of publication and mention of the grant of the patent: **23.09.2026**
(21) Application number: 23729545.6
(22) Date of filing: 04.05.2023
(51) Int. Cl.: G01R 29/08

(54) **RAPID SCANNING OF RADIATION PATTERNS USING ORTHOGONAL CODING**
SCHNELLE ABTASTUNG VON STRAHLUNGSMUSTERN UNTER VERWENDUNG VON ORTHOGONALER CODIERUNG
BALAYAGE RAPIDE DE DIAGRAMMES DE RAYONNEMENT AU MOYEN D'UN CODAGE ORTHOGONAL

(30) Priority: 14.10.2022 US 202263416387 P
(43) Date of publication of application: 20.08.2025
(73) Proprietor: ETS-Lindgren Inc., Cedar Park, TX 78613 (US)
(72) Inventor: FOEGELLE, Michael David, Bertram, Texas 78605 (US)
(74) Representative: Groth & Co. KB
(86) International application number: PCT/US2023/021040
(87) International publication number: WO 2024/081041

(56) References cited:
- CN-A- 106 872 806
- JP-A- 2010 217 062
- US-A1- 2009 237 092
- US-A1- 2013 169 485
- US-A1- 2018 080 967
- US-A1- 2020 271 709
- FOEGELLE MICHAEL D: "Simultaneous Measurement of Analog Phased Array Elements Using Orthogonal Coding", 2021 ANTENNA MEASUREMENT TECHNIQUES ASSOCIATION SYMPOSIUM (AMTA), AMTA, 24 October 2021 (2021-10-24), pages 1 - 6, XP034039035, DOI: 10.23919/AMTA52830.2021.9620624
- CHU R-S ET AL: "MULTIBAND PHASED-ARRAY ANTENNA WITH INTERLEAVED TAPERED-ELEMENTS AND WAVEGUIDE RADIATORS", IEEE ANTENNAS AND PROPAGATION SOCIETY INTERNATIONAL SYMPOSIUM 1996 DIGEST. BALTIMORE, JULY 21 - 26, 1996. HELD IN CONJUNCTION WITH THE USNC/URSI NATIONAL RADIO SCIENCE MEETING; [IEEE ANTENNAS AND PROPAGATION SOCIETY INTERNATIONAL SYMPOSIUM], NEW YORK, 21 July 1996 (1996-07-21), pages 1616 - 1619, XP000755285, ISBN: 978-0-7803-3217-1
- HE DONGLIN ET AL: "Dual-Band Shared-Aperture Base Station Antenna Array With Electromagnetic Transparent Antenna Elements", IEEE TRANSACTIONS ON ANTENNAS AND PROPAGATION, IEEE, USA, vol. 69, no. 9, 1 March 2021 (2021-03-01), pages 5596 - 5606, XP011876329, ISSN: 0018-926X, [retrieved on 20210901], DOI: 10.1109/TAP.2021.3061151
- PURDY D S: "An automated process for efficiently measuring the patterns of all elements located in a phased-array antenna", PHASED ARRAY SYSTEMS AND TECHNOLOGY, 2000. PROCEEDINGS. 2000 IEEE INTE RNATIONAL CONFERENCE ON DANA POINT, CA, USA 21-25 MAY 2000, PISCATAWAY, NJ, USA,IEEE, US, 21 May 2000 (2000-05-21), pages 521 - 524, XP010504645, ISBN: 978-0-7803-6345-8, DOI: 10.1109/PAST.2000.859010
- PARK SEJU ET AL: "Orthogonal Code-Based Transmitted Radiation Pattern Measurement Method for 5G Massive MIMO Antenna Systems", IEEE TRANSACTIONS ON ANTENNAS AND PROPAGATION, IEEE, USA, vol. 68, no. 5, 7 January 2020 (2020-01-07), pages 4007 - 4013, XP011786914, ISSN: 0018-926X, [retrieved on 20200504], DOI: 10.1109/TAP.2019.2963207

## Description

### CROSS REFERNCE TO RELATED APPLICATIONS

The present application claims priority to and the benefit of the filing date of U.S. Provisional Patent Application Serial No.63/416,387 filed on October 14, 2022.

### FIELD

The present technology is generally related to antenna pattern measurement and in particular, to systems and methods for scanning the radiation pattern of an individual antenna or an antenna array.

### BACKGROUND

For electrically large antennas like phased arrays, pattern measurements at far-field distances typically require prohibitively long range distances. A known method for performing such pattern measurements is to raster scan the radiation pattern in the near field, either on planar, cylindrical, or spherical grid points, and capture the near field magnitude and phase information at each grid point. Then, the far field pattern and other useful information may be computed from the near field magnitude and phase information. Traditionally these scans were performed by mechanically positioning a single probe antenna relative to the antenna under test (AUT), and manipulating the probe and/or AUT to complete the required scan surface.

Another known approach is to use a matrix of probes with a uniform spacing to replace or reduce the number of positions that must be scanned in at least one axis. By electrically switching between the probes, the measurement position can be changed almost instantaneously compared to mechanically moving a single probe to each position. A disadvantage of this method, especially for planar or cylindrical scanning where the probes are arrayed linearly, is that the required probe separation is typically one-half of a wavelength. Therefore, the mutual coupling of the probes can significantly affect their performance. Variations in impedance as different probes are activated can further impact the reading of each probe. These variations due to mutual coupling can impact the effective radiation pattern of the probe as well, and this impact can vary as a function of the location within the probe array. Even though the pattern of an individual probe may be known, its radiation pattern when in use as a near-field scanner may not be known. This impacts the ability to apply probe corrections to the near-to-far-field transform. Thus, the advantage in speed from using a probe matrix, as compared to a mechanically re-positioned probe, is potentially negated by higher measurement uncertainty.

In order to perform rapid near-field or far field scanning of an antenna under test, it is still desirable to be able to use an array of antenna elements covering the required grid of measurement points, while avoiding or compensating for the issues related to switching and mutual coupling. Modern phased arrays and the associated chipsets being developed for 5G millimeter wave (mmWave) applications offer some unique capabilities that can be applied to this problem. First, a common architecture of 4 elements (2x2) to a single chip allows for very symmetrical array designs that can be expanded in a uniform 2ⁿx2ⁿ array (e.g., 4x4, 8x8, 16x16) almost indefinitely, with other arrangements possible as well. These single chips are equipped with beamforming capabilities, providing amplitude and phase shift control of the signal to be transmitted and/or received by the phased array.

Phased arrays are commonly calibrated by iterating through each element in turn, by enabling and disabling each corresponding input or output amplifier, but this commonly has the same mutual coupling drawbacks as using the aforementioned matrix of probes for near-field or far field scanning and switching them on and off. In addition, variations in circuitry temperature as elements are enabled and disabled may also affect performance.

Another known method of calibrating each element of a phased array is to allow all of the elements to be active simultaneously and use orthogonal coding to extract the response from each individual element in near real-time. Traditionally, the Hadamard matrix is commonly used for producing orthogonal codes, such as the Walsh codes used for code division multiple access (CDMA), but use of these codes has limitations. First, the Hadamard matrices are dimensioned on the order of 2*^{k}*, where *k* is any positive real number. Thus, *2^{k}* orthogonal codes are available, each with *2^{k}* digits or symbols. This is useful for arrays that are also of dimension *2^{k},* i.e. a 64-element array. But for arrays having *2^{k}* + 1 antenna elements would require a Hadamard matrix of dimension *2*^{*R*+1}, thereby doubling the required number of symbols that must be transmitted in order to have just *2^{k}* + 1 codes. This results in a net doubling of the required test time, which becomes significant for large values of *k.* In addition, the multiplicative nature of calibrating each array element of an AUT with the full planar scanner makes having any additional overhead unbearable.

Another problem with the Hadamard matrix is that the first row and column are all ones, making the average of the first symbol and code both one, while all other symbols and codes average to zero. This results in a significant difference in the modulated result for the first symbol compared to all subsequent symbols (e.g.., all antenna elements being in-phase for the first symbol versus a fifty percent spread on subsequent symbols using binary phase shift keying (BPSK) modulation). This requires a measurement system with large dynamic range, and generally increases measurement uncertainty. Also, the Hadamard matrix assumes that the element that is assigned the first code remains essentially unmodulated (or at a fixed modulation) for the duration of the measurement (code sequence). This would result in the nonsensical result if, for example, the "1" state was chosen to be the off state of a binary on/off keying modulation, the antenna element being tested with that code would never be on, so no data could possibly be obtained on that element. Likewise, if that element were on all the time, it would suffer twice the amount of heating in the associated circuitry as any of the other elements that were only on half the time.

For at least these reasons, as well as because of the general state of the art in phased arrays, use of the Hadamard matrix codes to calibrate an array of antennas has not been adopted on a large scale by the industry and general interest in the method of orthogonal coding to scan the near field of an array of antennas has languished. However, with the advent of modern phased arrays for 5G mmWave applications, many of which contain large state buffers for holding codebooks and calibration results, interest in orthogonal coding is reviving. Driving this renewed interest are the goals of significantly decreasing the time to calibrate the array and significantly reducing measurement uncertainty.

Recent work in the application of orthogonal coding to array measurements has concentrated on determining and lowering overall measurement uncertainty and finding improved orthogonal codes that do not suffer the same problems as the traditional Hadamard matrix. This includes a method for virtually encoding leakage signals that appear in the measurement result but are not part of any of the signal paths that can be modulated by the array circuitry, and orthogonal matrix definitions that can be generated for any desired number of elements. FIG. 1 illustrates an example of a positioner which is configured to move a probe antenna in a plane that is orthogonal to the principal beam axis of the probe antenna. FIG. 2 is a schematic diagram of an RF portion of circuitry for a phased array antenna. FIG. 3 is an array of patch antenna elements. FIG. 4 is an array of bow-tie antenna elements. FIG. 5 is an array of Vivaldi antenna elements. FIG. 6 is an array of dual polarized bow-tie antenna elements. FIG. 7 is an array of dual polarized Vivaldi antenna elements.

US 2009/0237092 A1 discloses a sensor array having a plurality of modulated slots for microwave and/or millimeter wave imaging. US 2009/0237092 A1 discloses that the locations of the slots in the array define a spatial domain away from an object for detecting an electric field from the object, and that each of the slots outputs a signal representative of the measured field and the location of the slot. US 2009/0237092 A1 further discloses that a processor decodes the signals and generates an image of the object.

JP2010217062A discloses, according to an English machine translation of its abstract, evaluation antennas which are provided in an anechoic chamber and to be evaluated. Further according to the said English machine translation, transmission antennas are provided in the anechoic chamber and emit radio waves to the evaluation antennas, and a synthesis signal generation part gathers a series of data in an optional number of processing units into one group when dividing the series of data per constant processing unit, and multiplies the group of the series of data with a series of signs applying desired correlativity, so as to generate a plurality of synthesis signals. Further according to the said English machine translation, up-converters up-convert frequencies of the synthesis signals, and an evaluating part down-converts the radio waves received by the evaluation antennas and converts them to baseband signals for analyzing the characteristics of the antennas.

### SUMMARY

The invention is defined by the independent claims 1 and 7; further aspects of the invention are defined in the corresponding dependent claims. The techniques of this disclosure generally relate to methods and measurement systems for performing tests to determine electromagnetic behavior of an antenna under test (AUT). The methods and systems disclosed herein are beneficial for testing antennas having one antenna element or more than one antenna element, including a phased array antenna. A measurement system is configured with multiple antenna elements distributed in space and configured to receive and/or transmit RF signals. When the measurement system operates in a receive mode, each antenna element of the measurement system simultaneously receives a signal radiated by the AUT. These received signals are simultaneously encoded with different orthogonal codes. The encoded signals are combined into a composite signal, and the composite signal is decoded to extract measurements corresponding to each antenna element. When measured in the near field of the AUT, the extracted measurements indicate a near field pattern of the AUT and may be processed to determine an estimated far field pattern of the AUT. In some embodiments, the extracted measurements indicate a far field pattern measured directly by virtue of the measurement system being located a sufficient distance away from the AUT.

According to one aspect, a multi-sensor antenna measurement system is configured to measure an antenna under test (AUT). The system includes a first plurality of antenna elements, each antenna element of the first plurality of antenna elements being configured to simultaneously receive a radio frequency (RF) signal from the AUT. The system also includes RF circuitry configured to alter at least one of a gain and a phase of each RF signal received from an antenna element of the first plurality of antenna elements. A combiner (112) is configured to combine the received RF signals altered by the RF circuitry to produce a composite signal. Processing circuitry is configured to: control the RF circuitry to alter one of a gain and a phase of each received RF signal according to a different orthogonal code of a first set of orthogonal codes to encode the received RF signals before they are combined by the combiner. The processing circuitry is also configured to decode the composite signal using an orthogonal code by which a received RF signal is encoded to extract a measurement through at least one antenna element of the first plurality of antenna elements.

According to this aspect, in some embodiments, decoding includes determining a dot product of a row of an inverse of a code matrix of the first set of orthogonal codes and a vector of received RF signals. In some embodiments, an orthogonal code of the first set of orthogonal codes is reserved to represent a leakage path. In some embodiments, each symbol corresponding to an orthogonal code of the first set of orthogonal codes is offset by a symbol corresponding to the reserved orthogonal code. In some embodiments, a value of a leakage signal is decoded from measurement data based at least in part on applying the reserved orthogonal code to an RF signal received by an antenna element of the first plurality of antenna elements. In some embodiments, an orthogonal code of the set of orthogonal codes is applied for each polarization of an antenna element of the first plurality of antenna elements. In some embodiments, the first plurality of antenna elements forms a sparse array having an arrangement of antenna elements separated by more than half a wavelength at a highest frequency of operation of an antenna element of the arrangement. In some embodiments, the antenna elements of the arrangement are unequally spaced. In some embodiments, the first plurality of antenna elements includes a first set of at least one antenna element of the first plurality of antenna elements with a first operating frequency range and a second set of at least one antenna element of the first plurality of antenna elements with a second operating frequency range different from the first operating frequency range. In some embodiments, antenna elements of the first set of at least one antenna element are interstitially placed in the array between antenna elements of the second set of at least one antenna element. In some embodiments, the system also includes at least one mechanical positioner configured to adjust a relative orientation between antenna elements of the first plurality of antenna elements and the AUT. In some embodiments, the AUT is a phased array antenna and the processing circuitry is further configured to cause the AUT to encode an RF signal in each signal path connected to an antenna element of the AUT with a different orthogonal code of a second set of orthogonal codes.

According to another aspect, a method is provided for measurement of an antenna under test (AUT) by a measurement system having a first plurality of antenna elements distributed in space in a field of the AUT. The method includes simultaneously receiving a radiated signal from the AUT by each antenna element of the first plurality of antenna elements to produce a plurality of received signals. The method also includes orthogonally encoding each received signal with a different code of a first set of orthogonal codes. The method further includes combining the orthogonally encoded signals to produce a composite signal. The method also includes decoding the composite signal to determine a measurement through each of at least one antenna element of the plurality of antenna elements.

According to this aspect, in some embodiments, encoding each received signal includes altering at least one of a gain and a phase of the received signal according to a binary state of a code chip of an orthogonal code. In some embodiments, decoding the composite signal to determine a measurement through an antenna element of the first plurality of antenna elements include determining a dot product of a row of an inverse of a code matrix of the first set of orthogonal codes and a vector of the received signals. In some embodiments, an orthogonal code of the first set of orthogonal codes is reserved to represent a leakage path. In some embodiments, an orthogonal code of the first set of orthogonal codes is applied for each polarization of an antenna element of the plurality of antenna elements. In some embodiments, the AUT is a phased array and the method includes configuring the AUT to encode an RF signal in each signal path connected to an antenna element of the AUT with an orthogonal code of the first set of orthogonal codes. In some embodiments, simultaneously receiving the radiated signal from the AUT includes receiving the radiated signal by a first set of at least one antenna element of the plurality of antenna elements with a first operating frequency range and by a second set of at least one antenna element of the plurality of antenna elements with a second operating frequency range different from the first operating frequency range, the antenna elements of the first set being interstitially placed in a sparse array between antenna elements of the second set. In some embodiments, the AUT is a phased array antenna and the method further includes causing the AUT to encode an RF signal in each signal path connected to an antenna element of the AUT with a different orthogonal code of a second set of orthogonal codes.

According to yet another aspect, a multi-sensor antenna measurement system is configured to measure an antenna under test (AUT). The system also includes a splitter configured to split an RF signal into a plurality of signal paths. The system further includes RF circuitry in each path of the plurality of signal paths, the RF circuitry configured to alter at least one of a gain and a phase of the RF signal in the signal path according to a different orthogonal code of a first set of orthogonal codes to encode the RF signal in the signal path. The system also includes a plurality of antenna elements, each antenna element being configured to simultaneously transmit the encoded RF signals to the AUT. The system also includes processing circuitry configured to: control the RF circuitry to encode the RF signal in each signal path of the plurality of signal paths; and decode a signal received by the AUT with a first orthogonal code of the first set of orthogonal codes to determine a field measurement by the AUT corresponding to a field radiated from an antenna element corresponding to the first orthogonal code of the first set of orthogonal codes.

According to this aspect, in some embodiments, the antenna elements of the first plurality of antenna elements are configured in a sparse array having an arrangement of antenna elements separated by more than half a wavelength at a highest frequency of operation of an antenna element of the arrangement. In some embodiments, the antenna elements of the arrangement are unequally spaced. In some embodiments, the antenna elements of the sparse array include a first set of at least one antenna element of the first plurality of antenna elements with a first operating frequency range and a second set of at least one antenna element of the first plurality of antenna elements with a second operating frequency range different from the first operating frequency range. In some embodiments, antenna elements of the first set of at least one antenna element are interstitially placed in the sparse array between antenna elements of the second set of at least one antenna element. In some embodiments, the system also includes at least one mechanical positioner configured to adjust a relative orientation between the multi-sensor antenna measurement system and the AUT. In some embodiments, the AUT is a phased array antenna and the processing circuitry is further configured to cause the AUT to encode an RF signal in each signal path connected to an antenna element of the AUT with a different orthogonal code of a second set of orthogonal codes.

According to yet another aspect, a method is provided for testing an antenna under test (AUT) by a measurement system having a plurality of antenna elements distributed in space in the AUT. The method also includes encoding each of a plurality of signals with a different code of a set of orthogonal codes. The method also includes simultaneously transmitting each encoded signal into the field of the AUT to produce a radiated field. The method also includes receiving by the AUT the radiated field. The method also includes decoding the received radiated field to determine at least one field measurement by the AUT, each field measurement corresponding to the field radiated from an antenna element of the plurality of antenna elements.

According to this aspect, the method includes determining a far field radiation pattern of the AUT based on a plurality of field measurements. In some embodiments, the method includes processing the at least one field measurement to determine a radiation pattern of the AUT. In some embodiments, the AUT is a phased array and the method further includes encoding each signal received by an antenna element of the AUT with a different orthogonal code.

### BRIEF DESCRIPTION OF THE DRAWINGS

A more complete understanding, and the attendant advantages and features thereof, will be more readily understood by reference to the following detailed description when considered in conjunction with the accompanying drawings wherein:

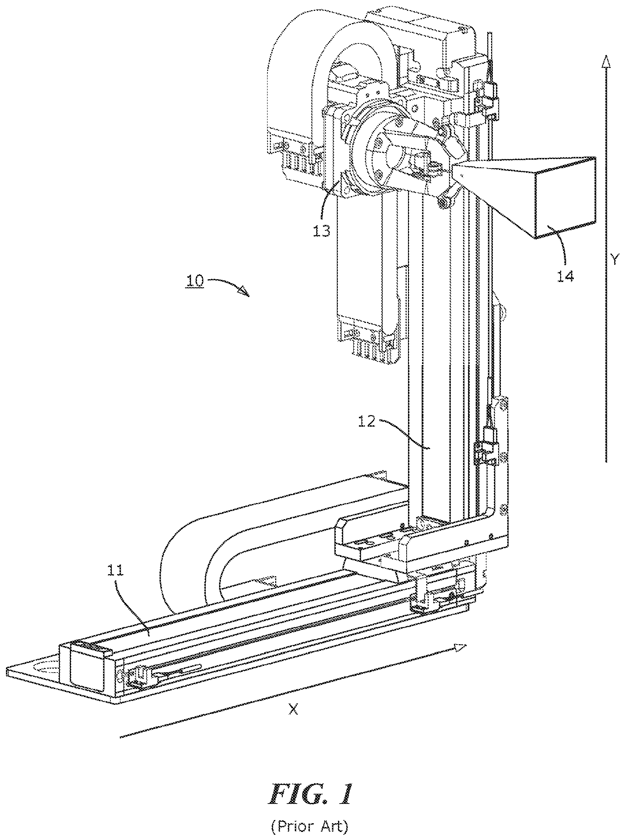

FIG. 1 illustrates an example of a positioner which is configured to move a probe antenna in a plane that is orthogonal to the principal beam axis of the probe antenna;

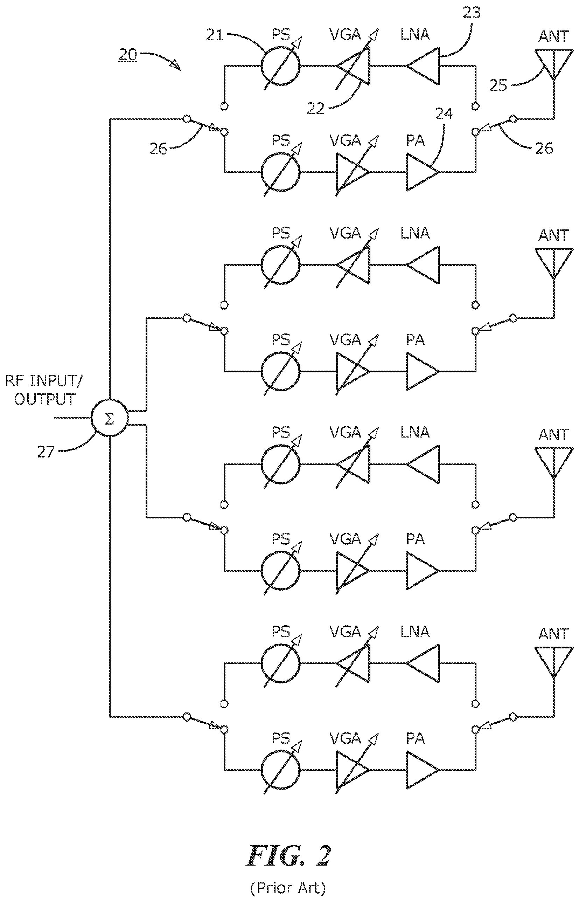

FIG. 2 is a schematic diagram of an RF portion of circuitry for a phased array antenna;

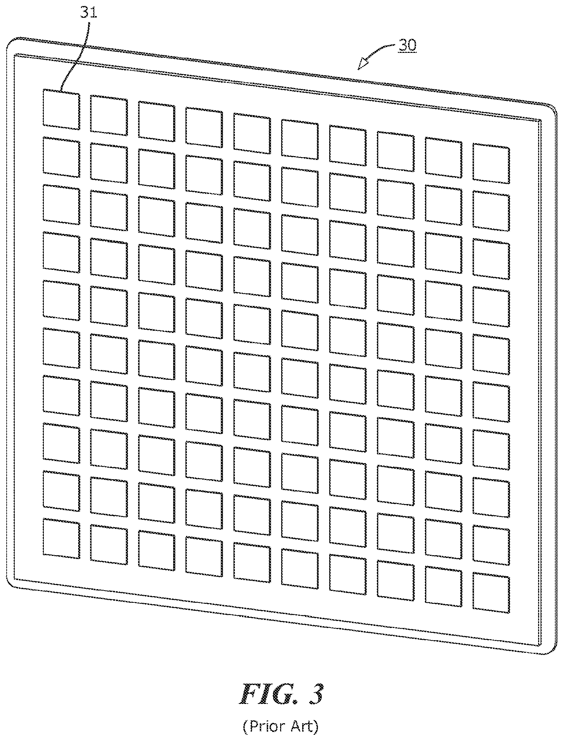

FIG. 3 is an array of patch antenna elements;

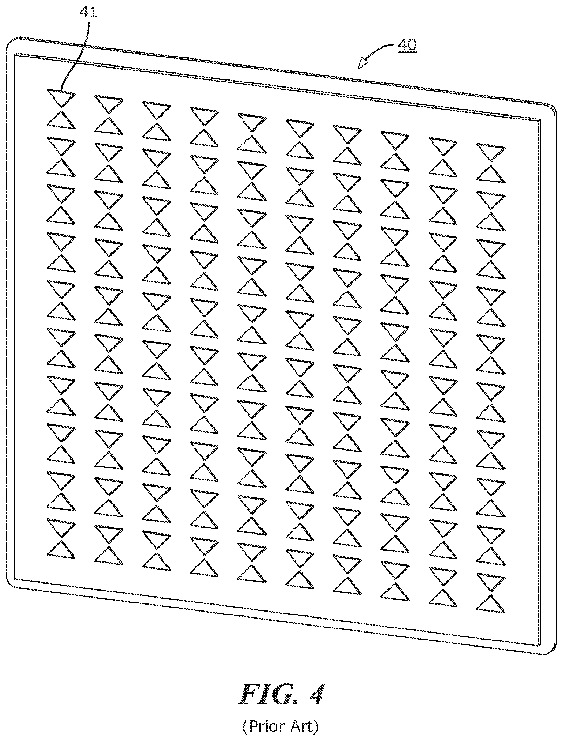

FIG. 4 is an array of bow-tie antenna elements;

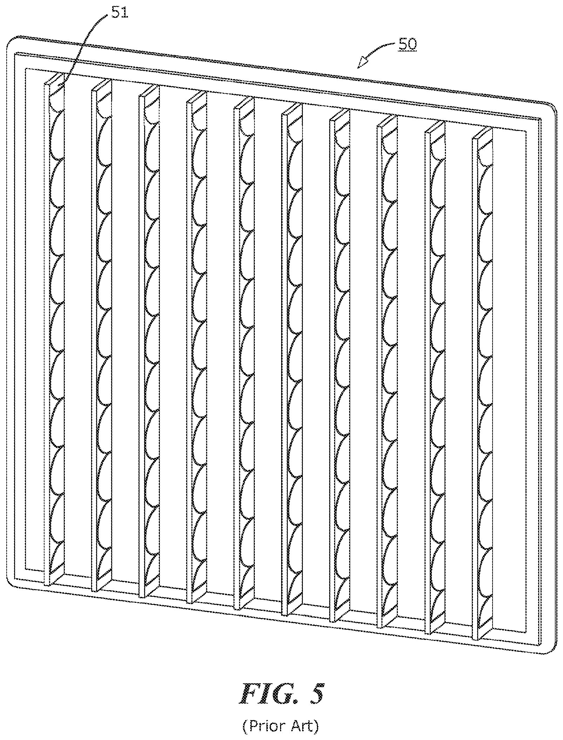

FIG. 5 is an array of Vivaldi antenna elements;

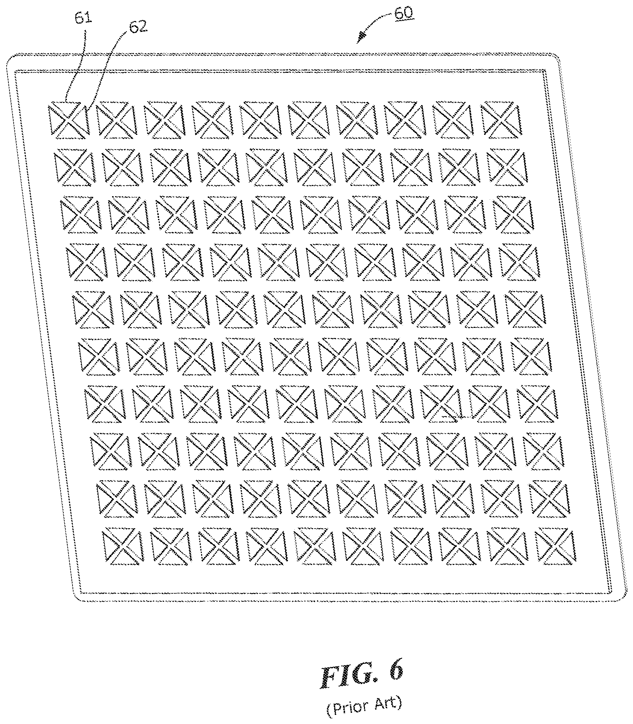

FIG. 6 is an array of dual polarized bow-tie antenna elements;

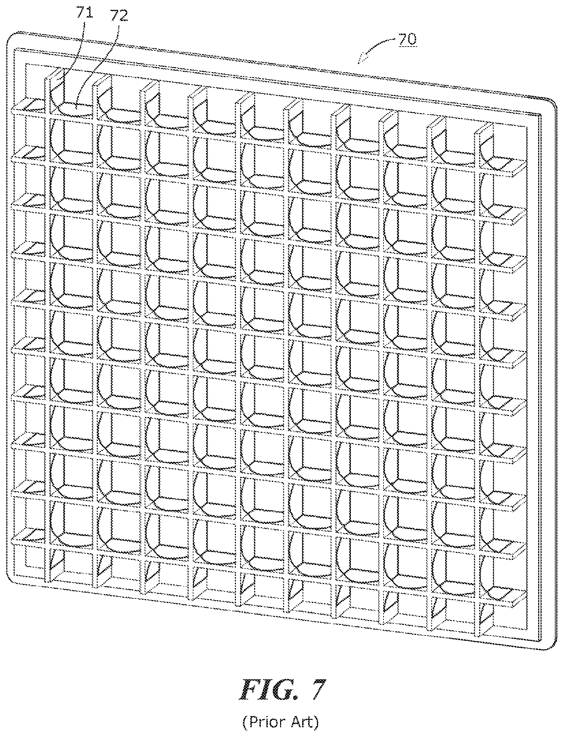

FIG. 7 is an array of dual polarized Vivaldi antenna elements;

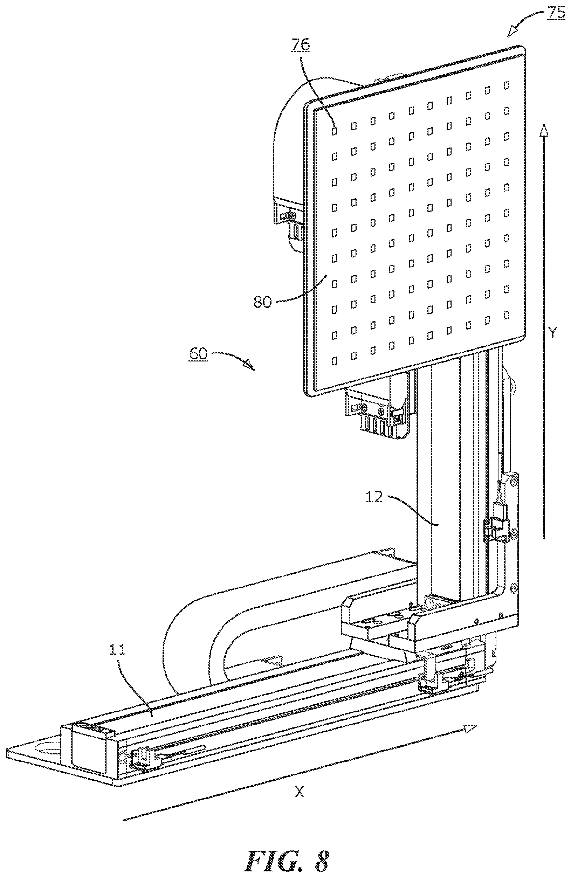

FIG. 8 illustrates a positioner which is configured to move a sparse array of antenna elements to the interstitial positions shown in FIG. 7;

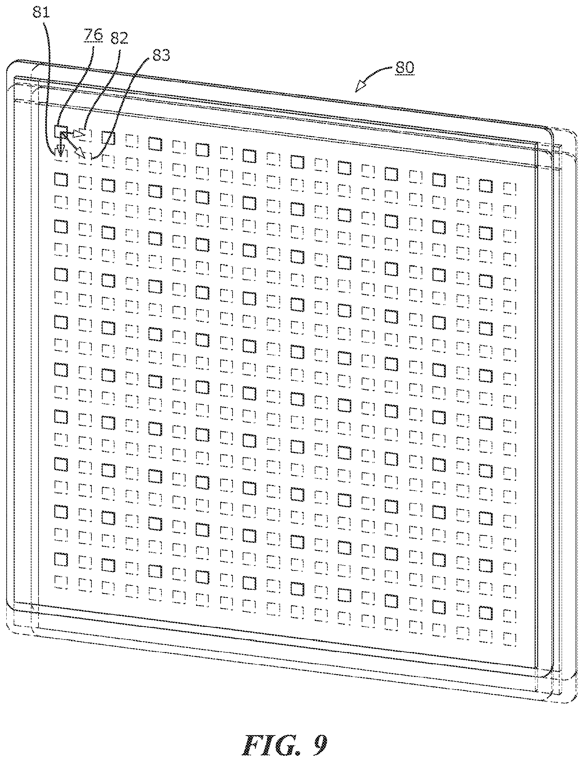

FIG. 9 illustrates a sparse array of antenna elements that may be moved to interstitial positions via vertical offset, horizontal offset and diagonal offset;

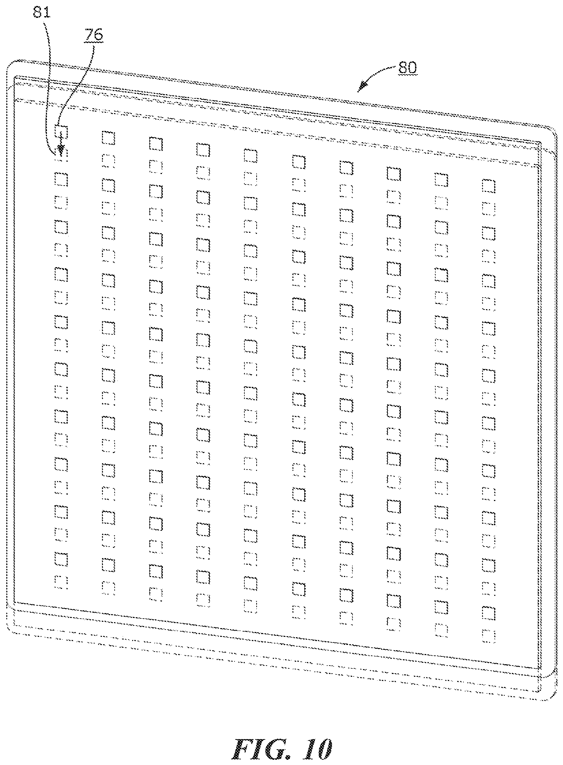

FIG. 10 illustrates movement of the sparse array of antenna elements to interstitial positions via vertical offset;

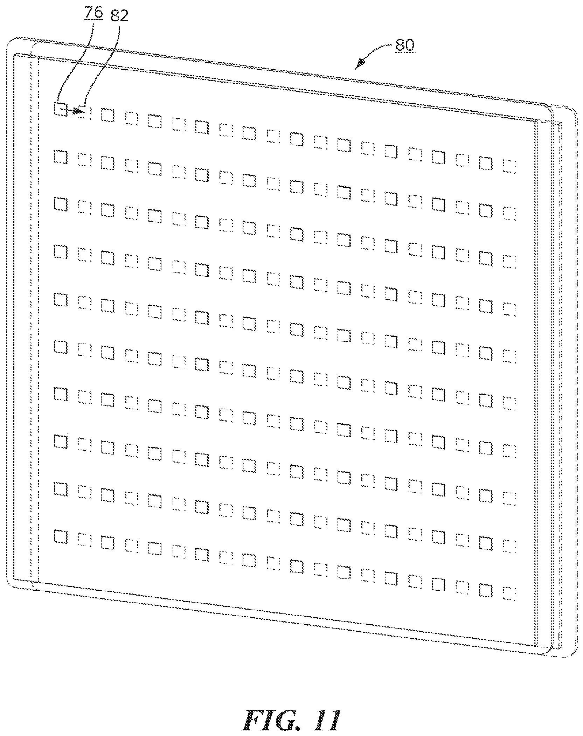

FIG. 11 illustrates movement of the sparse array of antenna elements to interstitial positions via horizontal offset;

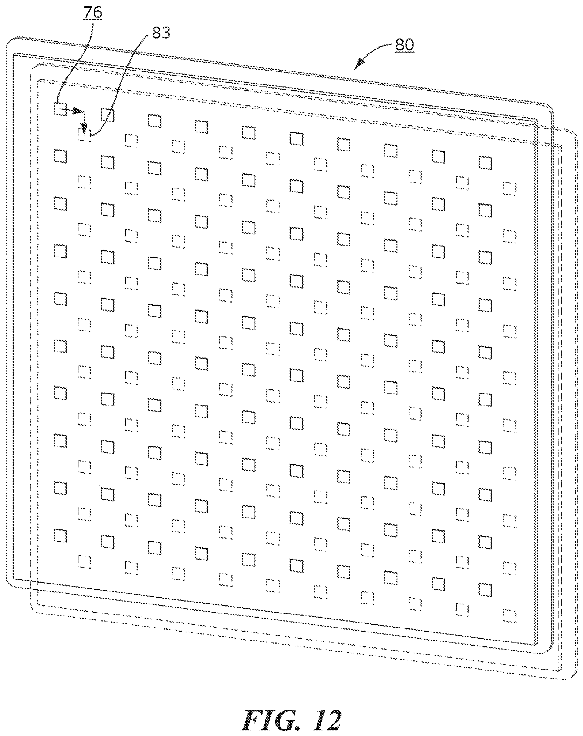

FIG. 12 illustrates movement of the sparse array of antenna elements to interstitial positions via horizontal offset and vertical offset;

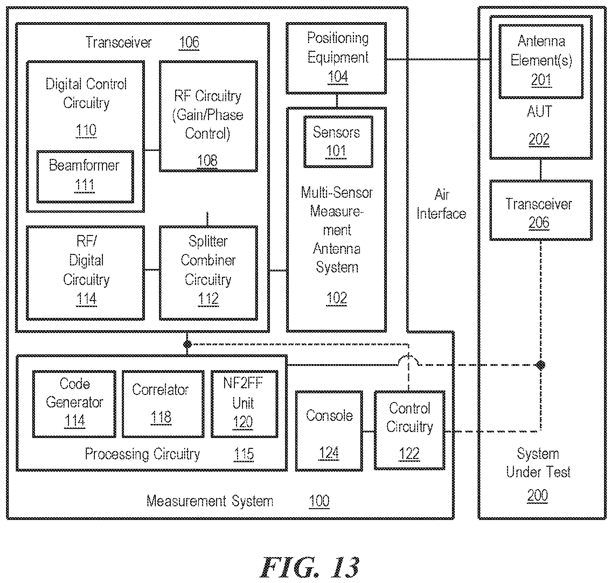

FIG. 13 is a block diagram of a measurement system configured according to principles disclosed herein, in over-the-air communication with a system under test;

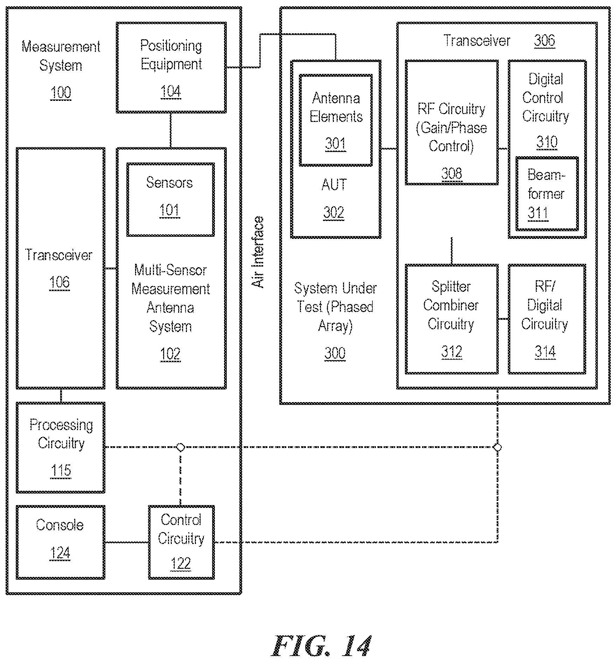

FIG. 14 is a block diagram of a system under test in over-the-air communication with a measurement system configured according to principles disclosed herein;

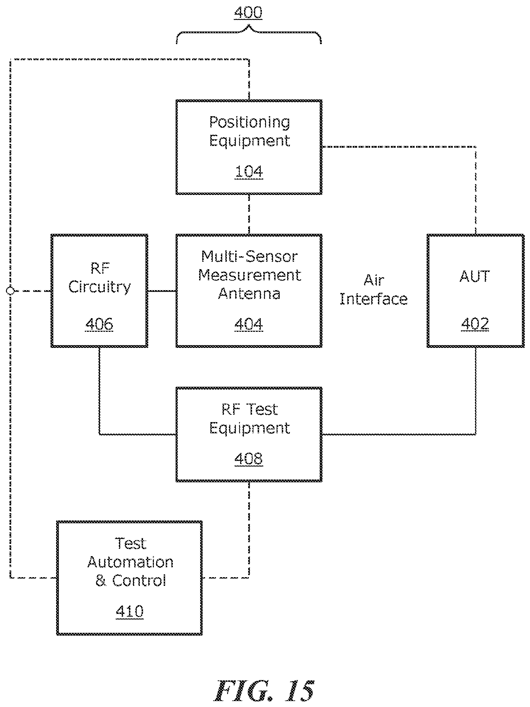

FIG. 15 is a block diagram of a measurement system configured to according to principles disclosed herein;

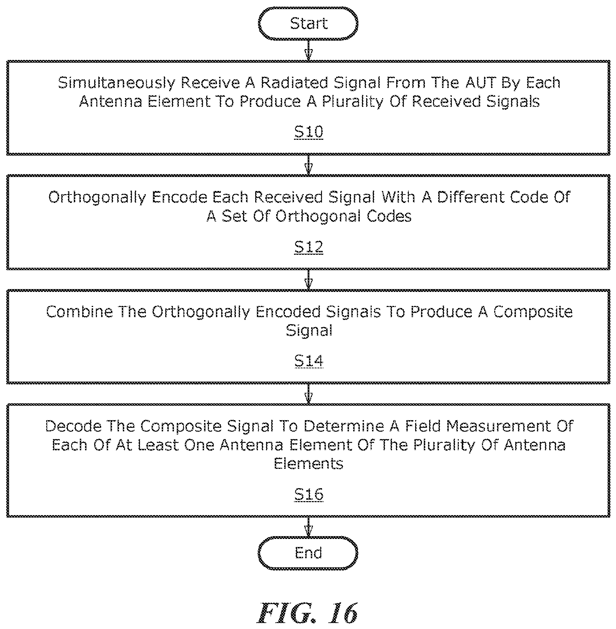

FIG. 16 is a flowchart of an example process in an antenna measurement system for testing an AUT; and

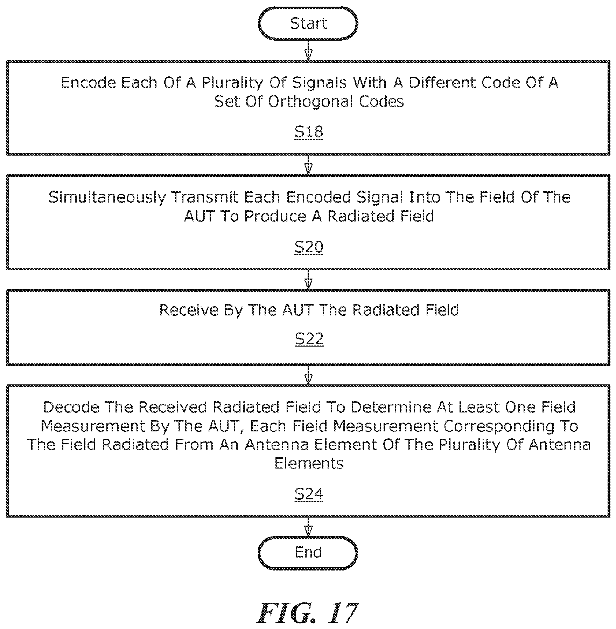

FIG. 17 is a flowchart of another example process in an antenna measurement system for testing an AUT.

### DETAILED DESCRIPTION

Some embodiments provide methods and measurement systems for performing tests to determine electromagnetic behavior of an antenna under test (AUT). These methods and systems are beneficial for testing antennas having one antenna element or more than one antenna element, including a phased array antenna. A measurement system is configured with multiple probe antenna elements distributed in space and configured to receive and/or transmit RF signals. When the measurement system operates in a receive mode, each antenna element of the measurement system simultaneously receives a signal radiated by the AUT. These received signals are simultaneously encoded with different orthogonal codes. The encoded signals are combined into a composite signal, and the composite signal is decoded to extract measurements corresponding to the location of each probe antenna element. The extracted measurements indicate a near field pattern of the AUT and may be processed to determine an estimated far field pattern of the AUT. When the measurement system operates in a transmit mode, the RF signals to be transmitted may be orthogonally encoded in each signal path prior to transmission. The combined signal received from the AUT can then be decoded to extract measurements corresponding to the receive radiation pattern of the AUT from each probe antenna location. Measurements performed in the near field may then be processed to determine an estimated far field pattern of the AUT.

Some embodiments include digital control circuitry to rapidly alter at least one of the gain and phase of each RF signal received or transmitted by an antenna element of a plurality of antenna elements of the measurement system to encode that RF signal. Each RF signal may be encoded with an orthogonal code of a set of orthogonal codes. Some embodiments also include processing circuitry configured to decode an encoded RF signal. The processing circuitry and the digital control circuitry may be colocated or separately located, or distributed among various circuit boards in the same or separate locations and may share common circuitry and/or may be controlled by one or more computers via a user interface.

Returning now to the drawing figures, where like reference numerals may indicate like elements, there is shown in FIG. 8 one example of a positioner 60 that may be employed according to principles disclosed herein to position a multi-sensor measurement antenna system 75 having a plurality of antenna elements 76 fixed in a sparse array 80. Note that although the sparse array 80 is shown in FIG. 8 to be planar, an array of antenna elements 76 that is not planar may be employed as the multi-sensor measurement antenna system 75. In some embodiments, the positioner 60 may further be configured to enable rotation of the multi-sensor measurement antenna system 75 or the AUT. Some embodiments may move either the probe array or the AUT in one or more axes of motion, resulting in relative motion between the probe array and AUT in Cartesian, cylindrical, or spherical coordinates. Note that the individual antenna elements 76 of the multi-sensor measurement antenna system 75 may themselves be referred to as antennas.

FIG. 9 illustrates how the positioner 60 may be configured to move the sparse array 80 so that the antenna elements 76 are shifted in space to interstitial positions 81, 82 and 83 via vertical offset, horizontal offset and/or diagonal offset of the sparse array 80. FIG. 10 shows vertical movement of the sparse array 80 of antenna elements 76 to interstitial positions 81. FIG. 11 shows horizontal movement of the sparse array 80 of antenna elements 76 to interstitial positions 82. FIG. 12 shows a combination of vertical movement and horizontal movement of the sparse array 80 of antenna elements 76 to interstitial positions 83. Note that although FIGS. 8-12 show patch antenna elements, some embodiments may use any of the antenna elements mentioned above, including bow-tie antenna elements, Vivaldi antenna elements, as well as combinations of these different antenna elements. Antenna elements with different frequency ranges (e.g. different sized patches) may be interlaced or arranged in a matrix and repeated across the probe array dimension to increase the total bandwidth over that of any one element design. Optional positioning equipment may then be used to position any of the interspersed sub-arrays to the desired measurement locations relative to the AUT. The antenna elements may be dual-polarized, circularly polarized or linearly polarized, for example. Some embodiments may use a probe array in a linear arrangement and use a second positioner to move the array or AUT relative to each other to scan a planar region. Some embodiments may have a probe array in a linear arrangement and use a second positioner to rotate the array or AUT relative to each other to scan a cylindrical region. Some embodiments may have a circular probe array and use a second positioner to move the array or AUT relative to each other in a direction along the array axis in order to scan a cylindrical region. Some embodiments may have a circular probe array and use a second positioner to rotate the array or AUT relative to each around an axis in the plane of the array ring in order to scan a spherical region. Some embodiments may use a cylindrical or spherical arrangement of probes to scan in the corresponding coordinates. All of these arrangements may use an additional positioner with motion in the direction of the array arrangement to position the array or AUT relative to each other at interstitial positions between the probe spacing.

FIG. 13 is a block diagram of an example measurement system 100 configured according to principles disclosed herein, in over-the-air communication with a system under test 200. The measurement system 100 includes a plurality of antenna elements 101 arranged in a multi-sensor measurement antenna 102. The multi-sensor measurement antenna 102, may be the multi-sensor measurement antenna system 75 with the sparse array 80 shown in FIG. 8. The multi-sensor measurement antenna 102 may be configured to receive a signal in the near field or far field radiated by antenna elements 201 of an antenna under test (AUT) 202. In some embodiments, the multi-sensor measurement antenna 102 may not be planar, but rather may exhibit curvature. The AUT 202 may be a phased array antenna or may be any other type of antenna.

In some embodiments, the multi-sensor measurement antenna 102 may be positionable by positioning equipment 104, which may include the positioner 60 and/or may include positioning equipment that rotates the multi-sensor measurement antenna 102, for example. Similarly, the AUT 202 may be positionable by positioning equipment 104, which may include the positioner 60 and/or may include positioning equipment that rotates the AUT 202.

The antenna elements 101 of the multi-sensor measurement antenna 102 are in communication with a transceiver 106. The transceiver 106 has RF circuitry 108 which is configured to control the gain and phase for each sensor signal to be transmitted or received by the antenna elements 101 of the multi-sensor measurement antenna 102. The gain and phase shift to be applied to each sensor signal is controlled by the digital control circuitry 110. The digital control circuitry may include a beamformer unit 111 configured to generate signals to steer or otherwise configure the spatial signature of the multi-sensor measurement antenna 102. For example, the beamformer unit 111 may generate beam forming weights (amplitude and/or phase) to steer a beam of the multi-sensor measurement antenna 102 to a particular area or part of the AUT 202.

When the measurement system 100 is configured to receive, the splitter/combiner circuitry 112, is configured to combine the signals from the antenna elements 101 (after amplification by the RF circuitry 108) into an RF signal. In some embodiments, the antenna elements 101 of the multi-sensor measurement antenna 102 may be arranged in groups and the signals from the antenna elements 101 in each group may be combined by the splitter/combiner circuitry 112. At this point, the received RF signal may be downconverted to baseband and digitized in a RF/digital circuitry 114 to produce a received digital signal. This received digital signal is output by the RF/digital circuitry 114 to be processed by processing circuitry 115. Alternatively, the received RF signal may be sampled by a VNA or other device capable of providing samples of an RF signal to produce the received digital signal.

The processing circuitry 115 includes a code generator 116 configured to generate a set of orthogonal codes. These codes may be used by the digital control circuitry 110 to adjust the phase and/or gain of the RF circuitry 108 to encode the signals to each antenna element 101 or group of antenna elements 101 by the orthogonal codes.

When the measurement system 100 is configured to receive the signal transmitted by the AUT 202, each orthogonal code of the set may be applied to the signal received by a different antenna element 101 or group of antenna elements 101 of the multi-sensor measurement antenna 102. The application of the orthogonal codes to respective signals from the antenna elements 101 may be performed in the analog domain by adjusting a gain (or attenuation) and/or phase of the received RF signal from each antenna element.101. Thus, the signals received by the antenna elements 101 or groups of antenna elements 101 are separately and orthogonally encoded. These encoded signals may then be combined by the splitter/combiner circuitry 112 to produce an RF signal. This RF signal is then a sum of the encoded signals from the antenna elements 101 or groups of antenna elements 101. As noted above, the RF signal may be downconverted to baseband by the RF/digital circuitry 114, which may include a downconverter to downconvert the RF signal to an intermediate frequency or to baseband and an analog-to-digital converter (ADC) to convert the downconverted signal to produce the received digital signal.

The output of the splitter/combiner circuitry 112 and/or the RF/digital circuitry 114includes the sum of the encoded signals from the antenna elements 101. Because the encoded signals are encoded by orthogonal codes, they can be separated by correlation. This correlation can be done in the analog domain and/or the digital domain, and may be performed at RF in some embodiments. Therefore, the processing circuitry 115 may include correlator 118 and/or signal processing hardware and/or software that is able to distinguish the different encoded signals from each other by successively correlating the combined signal with each code of the set of orthogonal codes generated by the code generator 116. In this way, the near field or far field of the AUT 202 may be simultaneously measured at up to as many points as there are antenna elements 101, and these measurements can then be distinguished by decoding. The time required to decode the signals from each antenna element 101 or group of antenna elements 101 may be less than the time required to successively perform a measurement by each antenna element 101 or group of antenna elements 101. In some embodiments, the correlations performed by the correlator 118 can be performed in parallel to further reduce the time required to decode the signals. In some embodiments, each individual encoded signal can be numerically decoded by taking a dot product of the digital signal from the RF/digital circuitry 114 with a row of the inverse of the encoding matrix.

The processing circuitry 115 may include a near-field-to-far-field (NF2FF) unit 120 which includes and executes one or more signal processing algorithms for numerically determining an estimate of the far field radiation pattern of the AUT 202.

The processing circuitry 115 and the system under test 200 may be controlled by control circuitry 122 under the directions of a user of the measurement system 100 via a computer console 124. The control circuitry 122 may be configured to generate control signal to cause the processing circuitry 115 to perform various functions including code generation, correlation and NF2FF conversion. The control circuitry 122 may also be configured to configure the transceiver 206 of the system under test 200 to receive or transmit over the air according to a spatial pattern of the AUT 202. In some embodiments, the control circuitry 122 may also be configured to configure the processing circuitry to send orthogonal codes to the transceiver 206 to be applied to the RF signals received or transmitted by the one or more antenna elements 101.

When the measurement system 100 is configured to transmit, the splitter/combiner circuitry 112 is configured to split an RF signal to be transmitted into as many paths as there are antenna elements 101 or groups of antenna elements 101 in the multi-sensor measurement antenna 102. Each signal produced by the split may be encoded by a different orthogonal code generated by the code generator 116, and may then be transmitted by a different antenna element 101 or subset of antenna elements 101 of the multi-sensor measurement antenna 102. When the AUT 202 is a phased array antenna, the encoded signals transmitted by the antenna elements 101 may be received by the AUT 202, processed by a transceiver 206, and separated by decoding in processing circuitry 115.

The processing circuitry 115 and control circuitry 122 may include one or more processors and associated memory. In particular, in addition to or instead of a processor, such as a central processing unit, and memory, the processing circuitry 115 and/or control circuitry 122 may comprise integrated circuitry for processing and/or control, e.g., one or more processors and/or processor cores and/or FPGAs (Field Programmable Gate Array) and/or ASICs (Application Specific Integrated Circuitry) adapted to execute instructions. The processing circuitry 115 and/or control circuitry 122 may be configured to access (e.g., write to and/or read from) memory, which may comprise any kind of volatile and/or nonvolatile memory, e.g., cache and/or buffer memory and/or RAM (Random Access Memory) and/or ROM (Read-Only Memory) and/or optical memory and/or EPROM (Erasable Programmable Read-Only Memory). In some embodiments, the processing circuitry 115 and the control circuitry 122 may each be in one location, such as on a same circuit board, or in separate locations, such as on different circuit boards in a same equipment housing or in different equipment housings that are themselves in the same or separate locations. In some embodiments, the processing circuitry 115 may be distributed and the control circuitry 122 may be distributed. In some embodiments, the control circuitry 122 includes the processing circuitry 115.

The processing circuitry 115 and/or control circuitry 122 may be configured to control any of the methods and/or processes described herein and/or to cause such methods, and/or processes to be performed, e.g., as may be directed by an operator of the console 124. The processing circuitry 115 and/or the control circuitry 122 may correspond to one or more processors for performing functions described herein. The console 124 also includes memory that is configured to store data, programmatic software code and/or other information described herein. In some embodiments, the software executed by a processor of the console 124 may include instructions that, when executed by the processor, causes the processor to perform the processes described herein with respect to the console 124. The instructions may be software associated with the console 124. In some embodiments, the positioning equipment 104 may be controlled by console 124 or may be controlled locally in proximity to the positioning equipment 104.

The processing circuitry 115 and/or control circuitry 122 may include a codebook buffer that may be used to store a set of gain and phase settings that may be applied to the received digital signal output by the RF/digital circuitry 114 or applied to the combined RF signal output by the splitter/combiner circuitry 112 to decode the received digital signal for each of a plurality of separate channels. Note that this may supplement or replace the operation of the beamformer 111. Thus, the processing circuitry 115 and/or control circuitry 122 includes hardware and software that may perform various functions described herein. The hardware and/or software may be distributed among the transceiver 106, processing circuitry 115 and/or control circuitry 122. Or, various functions attributable herein to the transceiver 106, processing circuitry 117 and/or control circuitry 122 may be combined in one integrated circuit chip or chipset.

FIG. 14 is a block diagram of one example of a system under test which includes a phased array 300. The phased array 300 includes the AUT 302 with antenna elements 301 and the transceiver 306. The AUT 302 may be positioned by positioning equipment 104 independently of or in coordination with the positioning of the multi-sensor measurement antenna 102. Signals received and transmitted by the antenna elements 301 are processed by the transceiver 306 and, in some embodiments, the processing circuitry 115.

The transceiver 306 of the phased array 300 may include RF circuitry 308 to amplify signals to be transmitted by each antenna element 301 and to amplify signals received by each antenna element 301. The RF circuitry 308 may operate under the direction of the digital control circuitry 310 to control the gain and/or phase of signals received by the AUT 302 and signals to be transmitted by the AUT 302. The digital control circuitry 310 includes the beamformer unit 311 to steer or otherwise shape the spatial signature of the AUT 302.

When the phased array 300 is configured to transmit, the splitter/combiner 312 splits an RF signal into as many paths as there are antenna elements 301 or groups of antenna elements 301. When the phased array 300 is configured to receive, the signals from each antenna element 301 or group of antenna elements 301 are combined by the splitter/combiner 312 into an RF signal to be processed. The RF signal may be processed by the RF/digital circuitry 314 to produce a received digital signal. In some embodiments, the received digital signal from the RF/digital circuitry 314 may be processed by the processing circuitry 115 under the direction of the control circuitry 122.

The code generator 116 of the processing circuitry 115 may be configured to generate a set of orthogonal codes that are used by the digital control circuitry 310 to encode signals to be transmitted over the air by the AUT 302 and to encode signals received over the air by the AUT 302. When the signals received over the air by each antenna element of the AUT 302 are encoded with different orthogonal codes, they may be combined by the splitter/combiner circuitry 312 into a combined RF signal. The combined RF signal may be separately correlated with different ones of the orthogonal codes to extract the signal received by each antenna element of the AUT 302. The orthogonal codes may be generated by the code generator 114 and the correlation may be performed by the correlator 118. Alternatively, the combined RF signal can be digitized by the RF/digital circuitry 314 and then correlated by the correlator 118 with one or more different orthogonal codes. In some embodiments, the signals may then be processed by a broad band signal analyzer to measure of multiple antenna elements at multiple frequencies, simultaneously. In some embodiments, the system under test 300 or any of its subcomponents 302, 308, 310, 312 and 314 may be controlled by a user via the console 124.

FIG. 15 is a block diagram of an example of a multi-sensor antenna measurement system 400 configured according to principles disclosed herein. The multi-sensor antenna measurement system 400 is configured to test an antenna under test (AUT) 402. The system 400 includes the positioning equipment 104 for positioning one or both of the AUT 402 and a multi-sensor measurement antenna 404, such as the multi-sensor measurement antenna 102. RF circuitry 406 may include one or both of a radio transmitter and a radio receiver, such as transceiver 106. RF test equipment 408 may include processing circuitry such as processing circuitry 115 and/or may include a vector network analyzer (VNA), for example. The VNA may be configured to generate a continuous wave (CW) signal and evaluate how that signal is altered in gain and phase via the AUT 402, multi-sensor measurement antenna 404 and RF circuitry 406. In some embodiments, RF test equipment 408 may include a vector signal generator (VSG) and/or chipset configured to generate a broadband signal with modulation used in wireless communications systems, such as 5G New Radio (NR) communication systems implemented according to standards developed by the Third Generation Partnership Project (3GPP). In some embodiments the RF test equipment 408 may include a vector signal analyzer (VSA) and/or chipset to decode each of a plurality of channels and/or subchannels and extract phase and amplitude information for each of the channels and/or subchannels.

In FIG. 15, the solid lines represent RF electrical signal paths connecting the AUT 402 and the RF circuitry 406 to the RF test equipment 408. Test automation and control block 410, which may be included in the console 124 or separate from console 124, may be configured to obtain results from the RF test equipment 408 and decode individual channels and/or subchannels. When the AUT 402 is an array of antenna elements 301, additional RF circuitry 314, which may be located in proximity to the AUT 402, such as behind the AUT 402, may be included, and be controlled by the test automation and control block 410. The dashed lines carry control signals and the dotted lines indicate one or more of mechanical linkage, electromotive force or other positioning apparatus.

FIG. 16 is a flowchart of an exemplary process for testing an AUT 202, 302 using a measurement system having a first plurality of antenna elements distributed in space in a field of the AUT. The process includes simultaneously receiving (Block S10) a radiated signal from the AUT by each antenna element of the first plurality of antenna elements to produce a plurality of received signals. The process also includes orthogonally encoding (Block S12) each received signal with a different code of a first set of orthogonal codes. The process further includes combining (Block S14) the orthogonally encoded signals to produce a composite signal. The process also includes decoding (Block S16) the composite signal to determine a measurement through each of at least one antenna element of the first plurality of antenna elements.

In some embodiments, encoding each received signal includes altering at least one of a gain and a phase of the received signal according to a binary state of a code symbol of an orthogonal code. In some embodiments, decoding the composite signal to determine a field measurement of an antenna element of the first plurality of antenna elements include determining a dot product of a row of an inverse of a code matrix of the set of orthogonal codes and a vector of the received signals. In some embodiments, an orthogonal code of the first set of orthogonal codes is reserved to represent a leakage path. In some embodiments, an orthogonal code of the first set of orthogonal codes is applied for each polarization of an antenna element of the first plurality of antenna elements. In some embodiments, the AUT is a phased array and the method includes configuring the AUT to encode an RF signal in each signal path connected to an antenna element of the AUT with an orthogonal code. In some embodiments, simultaneously receiving the radiated signal from the AUT includes receiving the radiated signal by a first set of at least one antenna element of the first plurality of antenna elements with a first operating frequency range and by a second set of at least one antenna element of the first plurality of antenna elements with a second operating frequency range different from the first operating frequency range, the antenna elements of the first set being interstitially placed in a sparse array between antenna elements of the second set. In some embodiments, the AUT is a phased array antenna and the method further includes causing the AUT to encode an RF signal in each signal path connected to an antenna element of the AUT with a different orthogonal code of a second set of orthogonal codes.

FIG. 17 is a flowchart of an exemplary process for testing an AUT 202, 302 using a measurement system having a plurality of antenna elements distributed in space in a field of the AUT. The process includes encoding (Block S18) each of a plurality of signals with a different code of a first set of orthogonal codes. The plurality of signals may be coherent. The process includes simultaneously transmitting (Block S20) each encoded signal into the field of the AUT to produce a radiated field. The process further includes receiving (Block S22) by the AUT the radiated field. The process also includes decoding (Block S24) the received radiated field to determine at least one field measurement by the AUT, each field measurement corresponding to the field radiated from an antenna element of the plurality of antenna elements.

In some embodiments, the method also includes determining a far field radiation pattern of the AUT based on a plurality of near field measurements. In some embodiments, the method also includes processing the at least one near field measurement to determine a radiation pattern of the AUT. In some embodiments, the AUT is a phased array and the method further includes encoding each signal received by an antenna element of the AUT with a different orthogonal code of a second set of orthogonal codes.

In some embodiments, when the AUT 202, 302, 402 is a phased array of individual antenna elements, software and/or hardware for decoding the received digital signal output by a receiver of one of the transceiver 106 and the RF circuitry 406 may implement a matrix multiplication of matrix having dimension N by a matrix of based on dimension M, which calls for NxM measurements. In some embodiments, the decoding includes iterating through each code in a first set of codes used to encode or decode signals of the transceiver 105/RF circuitry 406 and for each code in the first set code, iterating through each code of a second code set used to encode or decode signals of the transceiver 206, 307 or RF circuitry 406. In some embodiments the encoding/decoding process may be distributed between the measurement system 100 and the system under test 200, 300. Thus, in some embodiments, one or both of the measurement system 100 and the system under test 200, 300 may include different proprietary or non-proprietary hardware and/or software for coding/decoding.

Thus, some physical embodiments may combine multi-sensor measurement antenna element configurations in linear, arc, planar, cylindrical, spherical, or other arbitrary configurations. RF circuitry 108 having gain and/or phase control for each antenna element 101 in a transmit mode or a receive mode is also provided.

In some embodiments, splitter and combiner circuitry 112 for connecting the respective antenna elements 101 of the measurement system 100 to a single transmit signal path or receive signal path. RF test and measurement equipment of the measurement system 100 may be configured to cause transmission of a signal over the air from the multi-antenna measurement system 100 or from the antenna under test (AUT) 202, 302. The measurement system 100 may be configured to cause reception over the air of the transmitted signal and accurately determine the magnitude and phase of the resulting signal from an antenna under test 202, 302 or the system. Different embodiments of the multi-sensor measurement system 100 may incorporate narrow band antennas (e.g., patch antennas), or broadband antennas such as conical or bowtie elements or Vivaldi antenna elements. Elements may be single or dual polarized, circularly polarized and linearly polarized.

Spacings of the antenna elements 101 may be at a desired measurement resolution (e.g., one-half wavelength spacing or at a spacing chosen to achieve angular constraints) or sparsely spaced to address physical or other practical constraints.

Optional positioning equipment 104 may be used to manipulate the antenna elements 101 of the measurement system 100 and/or the AUT 202, 302 relative to each other in one or more linear directions or rotation axes. In some embodiments, an array of antenna elements 101 are provided at a set of fixed points in the array 80 and the array 80 may be translated and/or rotated to enable measurement of interstitial points in the field of the AUT between the fixed points of the set of fixed points in the array 80. In some embodiments, this enables measurement of larger scan area. In some embodiments, coarse positioning adjustment may be combined with a fine positioning adjustment to accomplish precise positioning in multiple stages.

In some embodiments, interferometers or other precise position feedback mechanisms in the positioning equipment 104 may be used to allow determination of and/or correction of positioning errors. A rotational axis may be provided to rotate the plurality of antenna elements 101 of the measurement system 100 and/or rotate the AUT 202, 302 to allow sequential measurement of two orthogonal polarizations. In some embodiments, dual polarized antenna elements 101 of the measurement system 100 enable capture of both polarizations simultaneously. In the case of dual polarization, each polarization may be routed to a separate receiver for simultaneous measurement. In some embodiments, a switch configured to select between two polarizations enables sequential measurement of each polarization. In some embodiments, the different polarizations are separately encoded with orthogonal codes to be separated using discrete codes for each antenna element 101 of the measurement system 100, according to the methods disclosed herein.

In some embodiments, the codes or symbols by which the signals for the antenna elements of the measurement system 100 and/or the AUT 202, 302 are encoded, are synchronized in time. In some embodiments, the measurements by the measurement system 100 are performed for every symbol of the codes by which the signals for each antenna element of the measurement system 100 are encoded.

Likewise, sub-arrays may be connected to individual synchronized transceivers 106 to allow for parallel measurement processing and reduced code sizes. In some embodiments, each element may be connected to an individual receiver. The RF circuitry 108, 308 may include power amplifiers, low noise amplifiers, and preamplifiers. These components may be provided for the AUT 202, 302 as wells as for the measurement system 100. Additional components may include up and down conversion as may be provided by RF/digital circuitry 114, 314, cabling, switching, rotary joints, waveguide converters, etc. In some embodiments, state buffers are coupled to each gain/phase control stage in the RF circuitry 108, 308 to allow desired gain/phase settings to be pre-defined, stored and rapidly retrieved. These components may be provided for the AUT 202, 303 as well as for the measurement system 101. In some embodiments, the desired gain and phase states may be retrieved by the control circuitry 122, via a control interface.

Coupled with the physical embodiments are methodological embodiments that can take the form of algorithms, computer code, control software/firmware, embedded hardware/software, manual processes, or other procedural and functional methods. For each antenna element 101, 201, 301 or signal path connected to a common RF signal path at each end (i.e., through a splitter/combiner network 112, 212, 313 to a given cable connection or through an over-the-air radiation path to another common point), a unique orthogonal code may be chosen. In some embodiments, these paths will be between a transmitter and measurement receiver (i.e., the measurement system 100), but multiple intermediate common points with separate possible coding paths are not precluded. As used herein a signal path is a separate path the connects an antenna element 101, 201, 301 with the splitter/combiner 112, 312. An adjustable amplifier of the RF circuitry 108, 308 is in each signal path, close to the antenna element 101 of that signal path.

Depending on the coding mechanism used, it may be desirable to reserve one or more codes to avoid using them for any active signal path. Likewise, a code may be reserved to allow for virtual encoding of any signals that may couple from the transmitter to receiver without following an encoded path. The codes may be chosen such that each symbol of the code may be applied to the signal paths using the available gain and phase control in the RF circuitry 108, 308, such that the linear combination of signals at the output of all of the paths remain orthogonal to each other. Generally, this may be some form of phase and/or amplitude keying.

One simple Hadamard matrix implementation supports binary phase-shift keying (BPSK) or binary on/off keying (BOOK), as well as binary amplitude keying with minimal error, provided the low power state is sufficiently below the high-power state.

More advanced orthogonal codes may call for higher orders of phase and/or gain control. Each symbol (i.e., each column of the orthogonal code matrix) may be processed via correlator 118 of the measurement system 100 to separate the signals from different antenna elements 101 of the measurement system 100 and/or the AUT 202, 302. A result of the encoding and measurement process is a vector of complex measured data (magnitude and phase). The term "vector" is used to refer to a set of measurements associated with the orthogonal coding matrix, rather than the common terminology for describing a given complex field or voltage measurement, e.g., with a vector network analyzer. The measurement for each individual signal path can be extracted by taking the dot product of the measured vector of complex measurements data with each row of the inverse of the encoding matrix (i.e., the decoding matrix).

In some embodiments, a code may be reserved to represent the leakage path. In this case, each symbol of the code for each desired path may be offset by the corresponding symbol from the reserved code prior by applying the codes to modulate the gain and/or phase of an amplifier of the RF circuitry 108, 308 to encode the signal in the signal path of an antenna element 101, thereby shifting the entire measured result by the reserved code. This has the effect of applying the reserved code to the source signal. When the total complex measurement result vector is obtained, the reverse offset of the reserved code may be applied to all of the measured data in order to compensate for the changes to each of the desired signal paths. Application of the offset and the reverse offset may be performed at least in part by the processing circuitry 115. This leaves the desired leakage code applied to the originally unmodulated signal that propagated from the transmitter to the receiver. Depending on the modulation method, the sign of the offset and the offset reversal should be chosen such that the sign of the leakage signal matches that of the reserved code. In some embodiments, the value of the leakage signal may also be decoded from the measured data. As used herein, the term transmitter may refer to the transmitter functionality of the transceiver 106, 206, 306 and/or RF circuitry 406. The term receiver may refer to the receiver functionality of the transceiver 106, 206, 306 and/or RF circuitry 406. Moreover, in some embodiments, a transceiver 106, 206, 306 and/or RF circuitry 406, may include only receiver functionality or only transmitter functionality.

In some embodiments, individual polarizations may be extracted from separate measurement paths by encoding and decoding each polarization separately via processing circuitry 115, for example. In some embodiments, such measurements may be performed sequentially by switching measurements between them. In some embodiments, polarization signals are combined, and larger codes are used to encode/decode all signal paths and polarizations.

In some embodiments, mechanical positioners 104 may be used to alter the relationship between the measurement system 100 and the AUT 202, 302 in order to measure additional spatial points. At each spatial offset, the encoding, measurement and decoding process may be repeated for all paths that are desired to be measured at the additional spatial points.

In some embodiments, only a subset of the antenna elements 101 of the measurement system 100 and/or the AUT 201, 301 may be used at each of at least one position. In some embodiments, sub-arrays may be used with independent measurement paths to reduce the total size of the required codes.

In some embodiments, the decoded measurement data may be used to calibrate the individual antenna elements 101 and signal paths of the measurement system 100. In some embodiments, physical offsets of the antenna elements 101 of the measurement system 100 may be used to perform transfer calibrations between each antenna element 101 of the measurement system 100 by exposing different areas of the array 80 to the same spatial signals and antenna pattern from the reference AUT 202, 302. In some embodiments, the radiation pattern of each antenna element 101, 301 of the AUT 202, 302 may be determined.

In some embodiments, resulting measured near-field data in a range of spatial positions may be used with one or more of several near-to-far-field (NF2FF) conversion algorithms 120 to generate far-field data for the AUT 202, 302. In some embodiments, NF2FF 120 may be applied to the measurement array 80 itself as part of a calibration process.

In some embodiments, the AUT 202, 302 may be a phased array 300. In some embodiments, the AUT 202, 302 may have gain and/or phase control that may also be used to apply orthogonal codes to each of the antenna elements 201, 301 of the AUT 202, 302. In some embodiments, a signal from each antenna element 301 of the phased array 300 may be encoded with a set of orthogonal codes for each symbol of the measurement system array 80 in order to obtain the radiation pattern of each antenna element 301 of the phased array 300. Alternately, each antenna element 403 may be tested individually. In some embodiments, the decoding of the AUT array element contribution may be done independently from the decoding of the probe array paths, or all of the data from each AUT and probe path combination may be maintained in a larger vector and solved at the end using the inverse of the product of the two coding matrices. In the latter case, the resulting vector will be of size NxM where N and M are the number of elements of the AUT and measurement probe arrays, respectively. In some embodiments the probe array coding may be iterated for each symbol of the AUT array.

In some embodiments, the test may be repeated for each of a plurality of frequencies. In some embodiments, spread spectrum techniques may be used to measure multiple frequencies simultaneously.

It should be understood that various aspects disclosed herein may be combined in different combinations than the combinations specifically presented in the description and accompanying drawings. It should also be understood that, depending on the example, certain acts or events of any of the processes or methods described herein may be performed in a different sequence, may be added, merged, or left out altogether (e.g., all described acts or events may not be necessary to carry out the techniques). In addition, while certain aspects of this disclosure are described as being performed by a single module or unit for purposes of clarity, it should be understood that the techniques of this disclosure may be performed by a combination of units or modules associated with, for example, a medical device.

In one or more examples, the described techniques may be implemented in hardware, software, firmware, or any combination thereof. If implemented in software, the functions may be stored as one or more instructions or code on a computer-readable medium and executed by a hardware-based processing unit. Computer-readable media may include non-transitory computer-readable media, which corresponds to a tangible medium such as data storage media (e.g., RAM, ROM, EEPROM, flash memory, or any other medium that can be used to store desired program code in the form of instructions or data structures and that can be accessed by a computer).

Instructions may be executed by one or more processors, such as one or more digital signal processors (DSPs), general purpose microprocessors, application specific integrated circuits (ASICs), field programmable logic arrays (FPGAs), or other equivalent integrated or discrete logic circuitry. Accordingly, the term "processor" as used herein may refer to any of the foregoing structure or any other physical structure suitable for implementation of the described techniques. Also, the techniques could be fully implemented in one or more circuits or logic elements.

It will be appreciated by persons skilled in the art that the present embodiments are not limited to what has been particularly shown and described herein above. In addition, unless mention was made above to the contrary, it should be noted that all of the accompanying drawings are not to scale. A variety of modifications and variations are possible in light of the above teachings without departing from the scope of the following claims.

## Claims

1. A multi-sensor antenna measurement system (100) configured to measure an antenna under test, AUT (202, 302), the system (100) comprising:
a first plurality of antenna elements (101), each antenna element (101) of the first plurality of antenna elements (101) being configured to simultaneously receive a radio frequency, RF, signal from the AUT (202, 302);
RF circuitry (108) configured to alter at least one of a gain and a phase of each RF signal received by an antenna element (101) of the first plurality of antenna elements (101);
a combiner (112) configured to combine the received RF signals altered by the RF circuitry (108) to produce a composite signal;
control circuitry (122) configured to:
control the RF circuitry (108) to alter one of a gain and a phase of each received RF signal according to a different orthogonal code of a first set of orthogonal codes to encode the received RF signals before they are combined by the combiner (112); and
decode the composite signal using a first orthogonal code by which a received RF signal is encoded to extract a measurement through at least one antenna element (101) of the first plurality of antenna elements (101), each symbol of the first orthogonal code being offset by a corresponding symbol of a reserved orthogonal code.

2. The system (100) of Claim 1, wherein decoding includes determining a dot product of a row of an inverse of a code matrix of the first set of orthogonal codes and a vector of received RF signals.

3. The system (100) of any of Claims 1 and 2, wherein an orthogonal code of the first set of orthogonal codes is reserved to represent a leakage path.

4. The system (100) of Claim 3, wherein a value of a leakage signal is decoded from measurement data based at least in part on applying the reserved orthogonal code to the received digital signal received by an antenna element (101) of the first plurality of antenna elements (101).

5. The system (100) of any of Claims 1-4, wherein an orthogonal code of the first set of orthogonal codes is applied for each polarization of an antenna element (101) of the first plurality of antenna elements (101).

6. The system (100) of any of Claims 1-5, wherein the first plurality of antenna elements (101) forms a sparse array having an arrangement of antenna elements (101) separated by more than half a wavelength at a highest frequency of operation of an antenna element (101) of the arrangement.

7. A method for measurement of an antenna under test, AUT (202, 302), by a measurement system (100) having a first plurality of antenna elements (101) distributed in space to measure a radiation pattern of the AUT (202, 302), the method comprising:
simultaneously (S10) receiving a radiated signal from the AUT (202, 302) by each antenna element (101) of the first plurality of antenna elements (101) to produce a plurality of received signals;
orthogonally encoding (S12) each received signal with a different code of a first set of orthogonal codes;
combining (S14) the orthogonally encoded signals to produce a composite signal; and
decoding (S16) the composite signal using a first orthogonal code to determine a measurement through each of at least one antenna element of the first plurality of antenna elements (101), each symbol of the first orthogonal code being offset by a corresponding symbol of a reserved orthogonal code.

8. The method of Claim 7, wherein encoding each received signal includes altering at least one of a gain and a phase of the received signal according to a binary state of a code symbol of an orthogonal code of the first set of orthogonal codes.

9. The method of any of Claims 7 and 8, wherein decoding the composite signal to determine a measurement through an antenna element (101) of the first plurality of antenna elements (101) include determining a dot product of a row of an inverse of a code matrix of the first set of orthogonal codes and a vector of the received signals.

10. The method of any of Claims 7-9, wherein an orthogonal code of the first set of orthogonal codes is reserved to represent a leakage path.

11. The method of any of Claims 7-10, wherein an orthogonal code of the first set of orthogonal codes is applied for each polarization of an antenna element (101) of the first plurality of antenna elements (101).

12. The method of any of Claims 7-11, wherein the AUT (202, 302) is a phased array and the method includes configuring the AUT (202, 302) to encode an RF signal in each signal path connected to an antenna element (101) of the AUT (202, 302) with an orthogonal code of the first set of orthogonal codes.

13. The method of any of Claims 7-12, wherein simultaneously receiving the radiated signal from the AUT (202, 302) includes receiving the radiated signal by a first set of at least one antenna element (101) of the first plurality of antenna elements (101) with a first operating frequency range and by a second set of at least one antenna element (101) of the first plurality of antenna elements (101) with a second operating frequency range different from the first operating frequency range, the antenna elements (101) of the first set being interstitially placed in a sparse array between antenna elements (101) of the second set.

14. The method of any of Claims 7-13, wherein the AUT (202, 302) is a phased array antenna and the method further includes causing the AUT (202, 302) to encode an RF signal in each signal path connected to an antenna element (101) of the AUT (202, 302) with a different orthogonal code of a second set of orthogonal codes.

## Patentansprüche

1. Multisensor-Antennenmesssystem (100), das konfiguriert ist, um eine zu prüfende Antenne, AUT (202, 302), zu messen, wobei das System (100) Folgendes umfasst:
eine erste Vielzahl von Antennenelementen (101), wobei jedes Antennenelement (101) der ersten Vielzahl von Antennenelementen (101) konfiguriert ist, um gleichzeitig ein Signal mit Funkfrequenz, RF, von der AUT (202, 302) zu empfangen;
eine RF-Schaltung (108), die konfiguriert ist, um mindestens eines von einer Verstärkung und einer Phase jedes durch ein Antennenelement (101) der ersten Vielzahl von Antennenelementen (101) empfangenen RF-Signals zu ändern;
einen Kombinierer (112), der konfiguriert ist, um die empfangenen RF-Signale, die durch die RF-Schaltung (108) geändert werden, zu einem zusammengesetzten Signal zu kombinieren;
eine Steuerschaltung (122), die konfiguriert ist, um:
die RF-Schaltung (108) zu steuern, um eines von einer Verstärkung oder einer Phase jedes empfangenen RF-Signals gemäß einem anderen orthogonalen Code aus einem ersten Satz von orthogonalen Codes zu ändern, um die empfangenen RF-Signale zu codieren, bevor sie durch den Kombinierer (112) kombiniert werden; und
das zusammengesetzte Signal unter Verwendung eines ersten orthogonalen Codes zu decodieren, mit dem ein empfangenes RF-Signal codiert ist, um eine Messung über mindestens ein Antennenelement (101) der ersten Vielzahl von Antennenelementen (101) zu erlangen, wobei jedes Symbol des ersten orthogonalen Codes um ein entsprechendes Symbol eines reservierten orthogonalen Codes versetzt ist.

2. System (100) nach Anspruch 1, wobei das Decodieren Bestimmen eines Skalarprodukts einer Zeile einer Umkehrung einer Codematrix des ersten Satzes von orthogonalen Codes und eines Vektors von empfangenen RF-Signalen beinhaltet.

3. System (100) nach einem der Ansprüche 1 und 2, wobei ein orthogonaler Code des ersten Satzes von orthogonalen Codes reserviert ist, um einen Leckpfad darzustellen.

4. System (100) nach Anspruch 3, wobei ein Wert eines Lecksignals basierend mindestens teilweise auf Anwenden des reservierten orthogonalen Codes auf das empfangene digitale Signal, das durch ein Antennenelement (101) der ersten Vielzahl von Antennenelementen (101) empfangen wird, aus Messdaten decodiert wird.

5. System (100) nach einem der Ansprüche 1 bis 4, wobei für jede Polarisation eines Antennenelements (101) der ersten Vielzahl von Antennenelementen (101) ein orthogonaler Code des ersten Satzes von orthogonalen Codes angewendet wird.

6. System (100) nach einem der Ansprüche 1 bis 5, wobei die erste Vielzahl von Antennenelementen (101) ein spärliches Array ausbildet, das eine Anordnung von Antennenelementen (101) aufweist, die bei einer höchsten Betriebsfrequenz eines Antennenelements (101) der Anordnung um mehr als eine halbe Wellenlänge getrennt sind.

7. Verfahren zur Messung einer zu prüfenden Antenne, AUT (202, 302), durch ein Messsystem (100), das eine erste Vielzahl von im Raum verteilten Antennenelementen (101) aufweist, um ein Strahlungsmuster der AUT (202, 302) zu messen, wobei das Verfahren Folgendes umfasst:
gleichzeitig (S10) Empfangen eines von der AUT (202, 302) ausgestrahlten Signals durch jedes Antennenelement (101) der ersten Vielzahl von Antennenelementen (101), um eine Vielzahl von empfangenen Signalen zu erzeugen;
orthogonales Codieren (S12) jedes empfangenen Signals mit einem anderen Code eines ersten Satzes von orthogonalen Codes;
Kombinieren (S14) der orthogonal codierten Signale, um ein zusammengesetztes Signal zu erzeugen; und
Decodieren (S16) des zusammengesetzten Signals unter Verwendung eines ersten orthogonalen Codes, um eine Messung über mindestens ein Antennenelement der ersten Vielzahl von Antennenelementen (101) zu bestimmen, wobei jedes Symbol des ersten orthogonalen Codes um ein entsprechendes Symbol eines reservierten orthogonalen Codes versetzt ist.

8. Verfahren nach Anspruch 7, wobei das Codieren jedes empfangenen Signals Ändern mindestens eines von einer Verstärkung und einer Phase des empfangenen Signals gemäß einem Binärzustand eines Codesymbols eines orthogonalen Codes des ersten Satzes von orthogonalen Codes beinhaltet.

9. Verfahren nach einem der Ansprüche 7 und 8, wobei das Decodieren des zusammengesetzten Signals, um eine Messung über ein Antennenelement (101) der ersten Vielzahl von Antennenelementen (101) zu bestimmen, Bestimmen eines Skalarprodukts einer Zeile einer Umkehrung einer Codematrix des ersten Satzes von orthogonalen Codes und eines Vektors der empfangenen Signale beinhaltet.

10. Verfahren nach einem der Ansprüche 7 bis 9, wobei ein orthogonaler Code des ersten Satzes von orthogonalen Codes reserviert ist, um einen Leckpfad darzustellen.

11. Verfahren nach einem der Ansprüche 7 bis 10, wobei für jede Polarisation eines Antennenelements (101) der ersten Vielzahl von Antennenelementen (101) ein orthogonaler Code des ersten Satzes von orthogonalen Codes angewendet wird.

12. Verfahren nach einem der Ansprüche 7 bis 11, wobei die AUT (202, 302) ein Phased-Array ist und das Verfahren Konfigurieren der AUT (202, 302) beinhaltet, um ein RF-Signal in jedem mit einem Antennenelement (101) der AUT (202, 302) verbundenen Signalpfad mit einem orthogonalen Code des ersten Satzes von orthogonalen Codes zu codieren.

13. Verfahren nach einem der Ansprüche 7 bis 12, wobei das gleichzeitige Empfangen des ausgestrahlten Signals von der AUT (202, 302) Empfangen des ausgestrahlten Signals durch einen ersten Satz von mindestens einem Antennenelement (101) der ersten Vielzahl von Antennenelementen (101) mit einem ersten Betriebsfrequenzbereich und durch einen zweiten Satz von mindestens einem Antennenelement (101) der ersten Vielzahl von Antennenelementen (101) mit einem zweiten Betriebsfrequenzbereich, der sich von dem ersten Betriebsfrequenzbereich unterscheidet, beinhaltet, wobei die Antennenelemente (101) des ersten Satzes in einem spärlichen Array zwischen den Antennenelementen (101) des zweiten Satzes interstitiell platziert sind.

14. Verfahren nach einem der Ansprüche 7 bis 13, wobei die AUT (202, 302) eine Phased-Array-Antenne ist und das Verfahren ferner Veranlassen der AUT (202, 302) beinhaltet, ein RF-Signal in jedem mit einem Antennenelement (101) der AUT (202, 302) verbundenen Signalpfad mit einem anderen orthogonalen Code eines zweiten Satzes von orthogonalen Codes zu codieren.

## Revendications

1. Système de mesure d'antenne multi-capteurs (100) configuré pour mesurer une antenne testée, AUT (202, 302), le système (100) comprenant :
une première pluralité d'éléments d'antenne (101), chaque élément d'antenne (101) de la première pluralité d'éléments d'antenne (101) étant configuré pour recevoir simultanément un signal radiofréquence, RF, de l'AUT (202, 302) ;
un circuit RF (108) configuré pour modifier au moins l'un d'un gain et d'une phase de chaque signal RF reçu par un élément d'antenne (101) de la première pluralité d'éléments d'antenne (101) ;
un combinateur (112) configuré pour combiner les signaux RF reçus modifiés par le circuit RF (108) pour produire un signal composite ;
un circuit de commande (122) configuré pour :
commander le circuit RF (108) de manière à modifier l'un d'un gain ou d'une phase de chaque signal RF reçu selon un code orthogonal différent d'un premier ensemble de codes orthogonaux afin de coder les signaux RF reçus avant qu'ils ne soient combinés par le combinateur (112) ; et
décoder le signal composite à l'aide d'un premier code orthogonal par lequel un signal RF reçu est codé pour extraire une mesure à travers au moins un élément d'antenne (101) de la première pluralité d'éléments d'antenne (101), chaque symbole du premier code orthogonal étant décalé par un symbole correspondant d'un code orthogonal réservé.

2. Système (100) selon la revendication 1, dans lequel le décodage comporte la détermination d'un produit scalaire d'une ligne d'une inverse d'une matrice de code du premier ensemble de codes orthogonaux et d'un vecteur de signaux RF reçus.

3. Système (100) selon l'une quelconque des revendications 1 et 2, dans lequel un code orthogonal du premier ensemble de codes orthogonaux est réservé pour représenter un chemin de fuite.

4. Système (100) selon la revendication 3, dans lequel une valeur d'un signal de fuite est décodée à partir de données de mesure sur la base au moins en partie de l'application du code orthogonal réservé au signal numérique reçu par un élément d'antenne (101) de la première pluralité d'éléments d'antenne (101).

5. Système (100) selon l'une quelconque des revendications 1 à 4, dans lequel un code orthogonal du premier ensemble de codes orthogonaux est appliqué à chaque polarisation d'un élément d'antenne (101) de la première pluralité d'éléments d'antenne (101).

6. Système (100) selon l'une quelconque des revendications 1 à 5, dans lequel la première pluralité d'éléments d'antenne (101) forme un réseau clairsemé ayant un agencement d'éléments d'antenne (101) séparés par plus d'une demi-longueur d'onde à la fréquence de fonctionnement la plus élevée d'un élément d'antenne (101) de l'agencement.

7. Procédé de mesure d'une antenne testée, AUT (202, 302), par un système de mesure (100) comportant une première pluralité d'éléments d'antenne (101) répartis dans l'espace pour mesurer un diagramme de rayonnement de l'AUT (202, 302), le procédé comprenant :
la réception simultanée (S10) d'un signal rayonné provenant de l'AUT (202, 302) par chaque élément d'antenne (101) de la première pluralité d'éléments d'antenne (101) pour produire une pluralité de signaux reçus ;
le codage orthogonal (S12) de chaque signal reçu avec un code différent d'un premier ensemble de codes orthogonaux ;
la combinaison (S14) des signaux codés orthogonalement pour produire un signal composite ; et
le décodage (S16) du signal composite à l'aide d'un premier code orthogonal pour déterminer une mesure à travers chacun des au moins un élément d'antenne de la première pluralité d'éléments d'antenne (101), chaque symbole du premier code orthogonal étant décalé par un symbole correspondant d'un code orthogonal réservé.

8. Procédé selon la revendication 7, dans lequel le codage de chaque signal reçu comporte la modification d'au moins l'un d'un gain et d'une phase du signal reçu selon un état binaire d'un symbole de code d'un code orthogonal du premier ensemble de codes orthogonaux.

9. Procédé selon l'une quelconque des revendications 7 et 8, dans lequel le décodage du signal composite pour déterminer une mesure à travers un élément d'antenne (101) de la première pluralité d'éléments d'antenne (101) comporte la détermination d'un produit scalaire d'une ligne d'une inverse d'une matrice de code du premier ensemble de codes orthogonaux et d'un vecteur des signaux reçus.

10. Procédé selon l'une quelconque des revendications 7 à 9, dans lequel un code orthogonal du premier ensemble de codes orthogonaux est réservé pour représenter un chemin de fuite.

11. Procédé selon l'une quelconque des revendications 7 à 10, dans lequel un code orthogonal du premier ensemble de codes orthogonaux est appliqué à chaque polarisation d'un élément d'antenne (101) de la première pluralité d'éléments d'antenne (101).

12. Procédé selon l'une quelconque des revendications 7 à 11, dans lequel l'AUT (202, 302) est un réseau phasé et le procédé comporte la configuration de l'AUT (202, 302) pour coder un signal RF dans chaque chemin de signal relié à un élément d'antenne (101) de l'AUT (202, 302) avec un code orthogonal du premier ensemble de codes orthogonaux.

13. Procédé selon l'une quelconque des revendications 7 à 12, dans lequel la réception simultanée du signal rayonné provenant de l'AUT (202, 302) comporte la réception du signal rayonné par un premier ensemble d'au moins un élément d'antenne (101) de la première pluralité d'éléments d'antenne (101) avec une première plage de fréquences de fonctionnement et par un second ensemble d'au moins un élément d'antenne (101) de la première pluralité d'éléments d'antenne (101) avec une seconde plage de fréquences de fonctionnement différente de la première plage de fréquences de fonctionnement, les éléments d'antenne (101) du premier ensemble étant placés de manière interstitielle dans un réseau clairsemé entre les éléments d'antenne (101) du second ensemble.

14. Procédé selon l'une quelconque des revendications 7 à 13, dans lequel l'AUT (202, 302) est une antenne à réseau phasé et le procédé comporte en outre le fait d'amener l'AUT (202, 302) à coder un signal RF dans chaque chemin de signal relié à un élément d'antenne (101) de l'AUT (202, 302) avec un code orthogonal différent d'un second ensemble de codes orthogonaux.
